# FASCICULE DE BREVET EUROPEEN

(11) **EP 4 221 256 B1**
(45) Date de publication et mention de la délivrance du brevet: **19.11.2025**
(21) Numéro de dépôt: 23153375.3
(22) Date de dépôt: 26.01.2023
(51) Int. Cl.: H04R 19/00, H04R 31/00, H04R 7/10, B81C 1/00, B81B 3/00

(54) **PROCÉDÉ DE FABRICATION D'UN TRANSDUCTEUR ÉLECTROACOUSTIQUE À FAIBLE BRUIT**
VERFAHREN ZUR HERSTELLUNG EINES RAUSCHARMEN ELEKTROAKUSTISCHEN WANDLERS
METHOD FOR MANUFACTURING A LOW NOISE ELECTROACOUSTIC TRANSDUCER

(30) Priorité: 28.01.2022 FR 2200754
(43) Date de publication de la demande: 02.08.2023
(73) Titulaire: Commissariat à l'Energie Atomique et aux Energies Alternatives, 75015 Paris (FR)
(72) Inventeur: DAGHER, Samer, 38054 GRENOBLE CEDEX 09 (FR)
(74) Mandataire: Cabinet Camus Lebkiri

(56) Documents cités:
- EP-A1- 2 541 222
- FR-A1- 3 059 659
- US-A- 5 456 111
- US-A1- 2012 260 500

## Description

### DOMAINE TECHNIQUE DE L'INVENTION

Le domaine technique de l'invention est celui des dispositifs de type microsystèmes électromécaniques (MEMS, pour « microelectromechanical systems » en anglais) ou nanosystèmes électromécaniques (NEMS, pour « nanoelectromechanical systems »). L'invention concerne plus particulièrement un procédé de fabrication d'un transducteur électroacoustique comprenant un dispositif de transmission d'un mouvement et d'une force entre deux zones isolées l'une de l'autre de manière étanche. Un tel transducteur électroacoustique peut être employé en tant que microphone ou haut-parleur.

### ARRIERE-PLAN TECHNOLOGIQUE DE L'INVENTION

Les microphones en microélectromécanique ou nanoélectromécanique représentent un marché en pleine expansion, notamment grâce au développement des appareils nomades, tels que les tablettes, téléphones portables intelligents (smartphones) et aux autres objets connectés, dans lesquels ils remplacent peu à peu les microphones à électret.

Les microphones mesurent une variation rapide de la pression atmosphérique, aussi appelée pression acoustique. Ils comportent donc au moins une partie en contact avec l'extérieur.

La plupart des microphones MEMS ou NEMS fabriqués actuellement sont des microphones à détection capacitive. La publication de brevet FR3059659A1 décrit un exemple de microphone à détection capacitive comprenant un élément mobile, des moyens de détection capacitive et un dispositif de transmission d'un mouvement entre l'élément mobile et les moyens de détection capacitive. La publication EP2541222A1 divulgue un dispositif similaire.

L'élément mobile est capable de récolter la variation de pression. Il peut être formé par un piston rigide comprenant une membrane, aussi appelée couche mince, et une structure de rigidification de la membrane. La membrane forme une séparation entre une cavité ouverte sur l'environnement extérieur et un volume arrière du microphone, aussi appelé volume de référence car il y règne une pression de référence. Ainsi, une face de la membrane est soumise à la pression de référence et une face opposée de la membrane est soumise à la pression atmosphérique (dont on souhaite détecter la variation). L'élément mobile est relié au dispositif de transmission de mouvement dans une première zone du microphone.

Les moyens de détection capacitive permettent de mesurer le déplacement du piston, et donc la variation de pression. Ils sont disposés dans une deuxième zone isolée de la première zone de manière étanche. Ils comprennent une électrode mobile et au moins une électrode fixe disposée en regard de l'électrode mobile. Les électrodes forment les armatures d'un condensateur dont la capacité varie en fonction du déplacement du piston. La deuxième zone est une chambre sous atmosphère contrôlée (typiquement sous vide) pour réduire les phénomènes de frottement visqueux et les bruits associés.

Le dispositif de transmission comprend au moins un premier bras de transmission s'étendant dans la première zone et au moins un deuxième bras de transmission s'étendant dans la deuxième zone. Le piston est couplé à une première extrémité du premier bras de transmission, tandis que l'électrode mobile des moyens de détection capacitive est couplée à une extrémité du deuxième bras de transmission. Les premier et deuxième bras de transmission sont reliés à leur deuxième extrémité par l'intermédiaire d'une articulation pivot. Cette articulation pivot autorise une rotation des bras de transmission par rapport au bâti du microphone et assure simultanément l'étanchéité entre les première et deuxième zones.

Un tel microphone à détection capacitive peut souffrir d'un phénomène d'amortissement, appelé « squeeze-film damping » en anglais, causé par un pincement d'air entre le piston et le bâti lors du fonctionnement du microphone. Ce phénomène d'amortissement génère du bruit mécanique et entraîne une diminution des performances du microphone.

### RESUME DE L'INVENTION

De manière plus générale, il existe un besoin de fabriquer un transducteur électroacoustique dans lequel le phénomène d'amortissement est réduit, le transducteur électroacoustique comprenant :
- un bâti ;
- un élément mobile par rapport au bâti, l'élément mobile comprenant une membrane et une structure de rigidification de la membrane ;
- un premier bras de transmission, l'élément mobile étant couplé à une extrémité du premier bras de transmission.

Ce besoin est satisfait par la présente invention telle que définie dans le procédé de fabrication d'un transducteur électroacoustique selon la revendication 1 et le transducteur électroacoustique selon la revendication 15.

Selon un premier aspect de l'invention, on tend à satisfaire ce besoin en prévoyant un procédé de fabrication comprenant les étapes suivantes :
- former une première couche sacrificielle sur un substrat, la première couche sacrificielle comprenant une première portion et une deuxième portion adjacente à la première portion, la première portion ayant une épaisseur supérieure à celle de la deuxième portion ;
- former une première couche structurelle sur la première couche sacrificielle, obtenant ainsi un empilement multicouche ;
- former une deuxième couche sacrificielle sur la première couche structurelle dans une première zone de l'empilement multicouche ;
- former une deuxième couche structurelle sur la première couche structurelle dans une deuxième zone de l'empilement multicouche et sur la deuxième couche sacrificielle dans la première zone de l'empilement multicouche, la deuxième zone étant adjacente à la première zone ;
- graver la deuxième couche structurelle de façon à exposer la deuxième couche sacrificielle dans la première zone et à délimiter la périphérie de la structure de rigidification de l'élément mobile dans la deuxième zone ;
- graver dans la deuxième zone la première couche structurelle jusqu'à la première couche sacrificielle de façon à délimiter la membrane de l'élément mobile ;
- graver la deuxième couche sacrificielle de façon à exposer une première face de la membrane ;
- graver le substrat de façon à délimiter le premier bras de transmission, la première couche sacrificielle servant de couche d'arrêt à la gravure du substrat ; et
- graver la première couche sacrificielle de façon à exposer une deuxième face opposée de la membrane et désolidariser la membrane du substrat ;
la première portion de la première couche sacrificielle étant configurée pour que, après l'étape de gravure de la première couche structurelle, une portion périphérique de la membrane soit disposée en regard de la première portion de la première couche sacrificielle.

La première portion de la première couche sacrificielle, d'épaisseur plus importante que la deuxième portion, permet d'augmenter la distance entre le substrat et la membrane de l'élément mobile, diminuant ainsi le phénomène d'amortissement (appelé « squeeze-film damping » en anglais) responsable de bruit mécanique.

Dans un mode de mise en œuvre préférentiel, le procédé de fabrication comprend, avant l'étape de formation de la première couche sacrificielle, une étape de gravure d'une cavité dans le substrat, la première portion de la première couche sacrificielle remplissant entièrement la cavité et la deuxième portion de la première couche sacrificielle étant disposée en dehors de la cavité.

La première couche structurelle peut être formée par épitaxie sur la première couche sacrificielle.

Alternativement, l'étape de formation de la première couche structurelle comprend les sous-étapes suivantes :
- fournir un substrat de report comprenant la première couche structurelle ;
- coller la première couche structurelle du substrat de report à la première couche sacrificielle ;
- amincir le substrat de report jusqu'à atteindre la première couche structurelle.

Le procédé de fabrication peut comprendre en outre, après l'étape de gravure de la deuxième couche sacrificielle et avant l'étape de gravure du substrat, les étapes suivantes :
- disposer un capot sur la deuxième couche structurelle, formant ainsi un assemblage ; et
- retourner l'assemblage.

Outre les caractéristiques qui viennent d'être évoquées dans les paragraphes précédents, le procédé de fabrication selon l'invention peut présenter une ou plusieurs caractéristiques complémentaires parmi les suivantes, considérées individuellement ou selon toutes les combinaisons techniquement possibles :
- la cavité présente une profondeur supérieure ou égale à 1 µm, de préférence comprise entre 2 µm et 10 µm ;
- la cavité présente une forme annulaire et, de préférence, s'étend sur plus de 80 % de la périphérie de l'élément mobile ;
- la cavité et la membrane sont de même forme, de préférence de forme rectangulaire ;
- la cavité présente des dimensions supérieures ou égales aux dimensions de la membrane ;
- la première couche structurelle et la deuxième couche structurelle sont gravées simultanément de façon à délimiter la membrane et la structure de rigidification de l'élément mobile ;
- le substrat est en silicium, la première couche sacrificielle est en oxyde de silicium et la première couche structurelle est en silicium ;
- la deuxième couche sacrificielle est en oxyde de silicium ;
- la première couche structurelle présente une épaisseur comprise entre 100 nm et 10 µm ;
- la structure de rigidification de l'élément mobile repose au moins en partie sur la membrane ; et
- la structure de rigidification de l'élément mobile est en contact avec la membrane.

Un deuxième aspect de l'invention concerne un transducteur électroacoustique comprenant :
- un bâti ;
- un élément mobile par rapport au bâti, l'élément mobile comprenant une membrane et une structure de rigidification de la membrane ;
- un premier bras de transmission, l'élément mobile étant couplé à une extrémité du premier bras de transmission ;

la membrane étant formée par une première partie d'une première couche structurelle, la structure de rigidification étant formée par une première partie d'une deuxième couche structurelle disposée sur la première couche structurelle et le bâti comprenant un substrat, une deuxième partie de la première couche structurelle et une deuxième partie de la deuxième couche structurelle,
et dans lequel la distance entre le substrat et une portion périphérique de la membrane est supérieure à la distance entre le substrat et la deuxième partie de la première couche structurelle, lesdites distances étant mesurées perpendiculairement à des faces de la membrane.

Dans un mode de réalisation préférentiel du transducteur électroacoustique, le substrat comprend une cavité disposée en regard de la portion périphérique de la membrane.

Le transducteur peut comprendre en outre un dispositif de transmission d'un mouvement et d'une force entre une première zone et une deuxième zone à atmosphère contrôlée, les première et deuxième zones étant isolées l'une de l'autre de manière étanche, le dispositif de transmission comprenant, outre le premier bras de transmission qui s'étend dans la première zone, un deuxième bras de transmission s'étendant dans la deuxième zone.

L'invention et ses différentes applications seront mieux comprises à la lecture de la description qui suit et à l'examen des figures qui l'accompagnent.

### BREVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
[Fig. 1] représente schématiquement et partiellement un exemple de transducteur électroacoustique comprenant un piston relié à deux premiers bras de transmission ;
[Fig. 2A] à [Fig. 2H] représentent en vue de coupe des étapes d'un procédé de fabrication du transducteur électroacoustique selon la figure 1 ;
[Fig. 3A] à [Fig. 3J] représentent en vue de coupe des étapes d'un procédé de fabrication de transducteur électroacoustique selon un mode de mise en œuvre préférentiel de l'invention, reprenant les étapes des figures 2B à 2H ; et
[Fig. 4] représente une variante de mise en œuvre de l'étape de la figure 3C.

Pour plus de clarté, les éléments identiques ou similaires sont repérés par des signes de référence identiques sur l'ensemble des figures.

### DESCRIPTION DETAILLEE

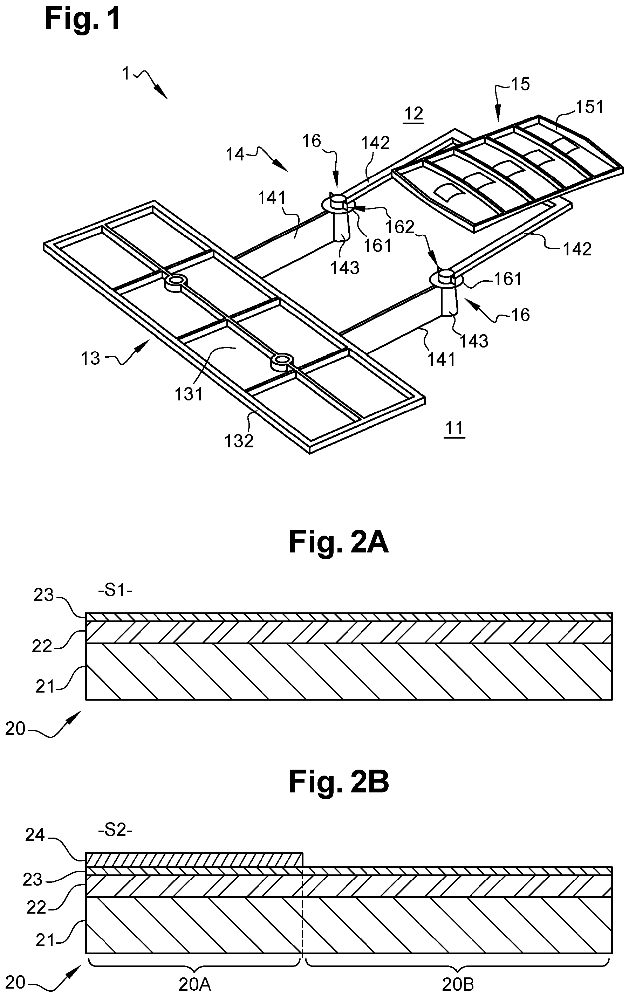

La figure 1 montre un exemple de transducteur électroacoustique 1, de type microphone à détection capacitive.

Le transducteur électroacoustique 1 comprend un bâti (non représenté) délimitant au moins en partie une première zone 11 et une deuxième zone 12, un élément mobile 13 par rapport au bâti et un dispositif de transmission 14 d'un mouvement entre la première zone 11 et la deuxième zone 12. Les première et deuxième zones 11-12 du transducteur électroacoustique 1 sont soumises à des pressions différentes. Elles sont isolées l'une de l'autre de manière étanche.

L'élément mobile 13, appelé ci-après piston, est en contact avec la première zone 11. Il comprend une membrane 131 et une structure de rigidification 132 de la membrane, aussi appelée squelette ou armature. La membrane 131 du piston 13 a ici pour rôle de récolter sur toute sa surface une différence de pression entre ses deux faces, pour en déduire une variation de la pression atmosphérique.

La membrane 131 du piston 13 délimite en partie un volume fermé dit de référence, où règne une pression de référence. Elle sépare ce volume de référence d'une cavité ouverte sur l'environnement extérieur, ici l'air. Une face de la membrane 131 est donc soumise à la pression de référence et une face opposée de la membrane 131 est soumise à la pression atmosphérique (dont on souhaite détecter la variation dans le cas d'un microphone).

La première zone 11 peut correspondre à la cavité ouverte sur l'environnement extérieur, et donc être soumise à la pression atmosphérique. Alternativement, la première zone 11 peut être le volume de référence soumis à la pression de référence.

En outre, dans cet exemple particulier, le transducteur électroacoustique 1 comprend des moyens de détection capacitive 15 disposés dans la deuxième zone 12. Ces moyens de détection capacitive 15 permettent de mesurer le déplacement du piston 13, et donc la différence de pression entre ses deux faces. Ils comprennent de préférence une électrode mobile 151 et au moins une électrode fixe disposée en regard de l'électrode mobile 151. Les électrodes forment les armatures d'un condensateur dont la capacité varie en fonction du déplacement du piston 13.

La deuxième zone 12 est une chambre sous atmosphère contrôlée pour réduire les phénomènes de frottement visqueux et les bruits acoustiques associés. Par « chambre sous atmosphère contrôlée », on entend une chambre sous une pression réduite, typiquement inférieure à 10 mbar, et de préférence sous vide.

Le dispositif de transmission 14 est monté mobile en rotation par rapport au bâti, au moyen d'une ou plusieurs articulations pivot 16. Le dispositif de transmission 14 comprend au moins un premier bras de transmission 141 s'étendant dans la première zone 11, au moins un deuxième bras de transmission 142 s'étendant dans la deuxième zone 12 et au moins un arbre de transmission 143 s'étendant en partie dans la première zone 11 et en partie dans la deuxième zone 12. Dans l'exemple de la figure 1, le dispositif de transmission 14 comprend deux premiers bras de transmission 141, deux deuxièmes bras de transmission 142 et deux arbres de transmission 143, chaque arbre de transmission 143 reliant un premier bras de transmission 141 à un deuxième bras de transmission 142.

Chaque premier bras de transmission 141 comprend une première extrémité couplée au piston 13 et une deuxième extrémité opposée, couplée à l'arbre de transmission 143 associé. Chaque deuxième bras de transmission 142 comprend une première extrémité couplée à l'électrode mobile 151 des moyens de détection capacitive 15 et une deuxième extrémité opposée, couplée à l'arbre de transmission 143 associé.

L'arbre de transmission 143 est par exemple en forme de cylindre droit. Les bras de transmission 141-142 ont de préférence la forme d'une poutre de section rectangulaire, avec une dimension (longueur) bien supérieure aux autres (largeur et épaisseur). Le piston 13 a par exemple une forme rectangulaire. Les premiers bras de transmission 141 s'étendent de préférence perpendiculairement à un côté du piston 13, avantageusement un grand côté. Ils peuvent être ancrés à l'intérieur de la périphérie du piston 13, comme cela est représenté par la figure 1, par exemple au moyen d'une première extrémité de forme cylindrique.

Chaque articulation pivot 16 comprend de préférence un élément d'isolation étanche 161, traversé par un arbre de transmission 143, et deux lames 162 alignées, qui s'étendent entre l'arbre de transmission 143 et le bâti. L'élément d'isolation étanche 161 se présente par exemple sous la forme d'une membrane d'étanchéité. Il assure l'étanchéité entre la première zone 11 et la deuxième zone 12 au niveau de l'articulation pivot 16. Les lames 162 sont dimensionnées de sorte à pouvoir se déformer en torsion et permettre la rotation du dispositif de transmission 14. Elles sont de préférence disposées de façon diamétralement opposée par rapport à l'arbre de transmission 143. De préférence, l'élément d'isolation étanche 161 est tel qu'il se déforme également sous l'effet du déplacement en rotation du dispositif de transmission 14.

Le bâti peut notamment comprendre un support (formé par un premier substrat), une couche structurelle (par exemple en silicium) disposée sur le support et un capot rapporté sur la couche structurelle (par exemple formé par un deuxième substrat).

La structure de rigidification 132 de la membrane du piston 13 comprend avantageusement à sa périphérie un rebord qui s'étend dans une direction perpendiculaire à la membrane 131. Ce rebord augmente le chemin de l'air autour du piston et réduit les fuites entre l'environnement extérieur et le volume fermé servant de référence.

Les figures 2A à 2H représentent des étapes S1 à S8 d'un procédé de fabrication du transducteur électroacoustique 1. Ces figures montrent de quelle façon le piston 13 peut être formé et désolidarisé du bâti. Seulement une partie du transducteur électroacoustique, au voisinage de la périphérie du piston 13, est donc représentée. Dans un souci de simplification, il ne sera fait référence qu'à un seul premier bras de transmission 141, une seule articulation pivot 16, une seule membrane d'étanchéité 161..., étant entendu que tous les éléments d'un même type peuvent être formées simultanément.

La première étape S1 représentée par la figure 2A consiste à fournir un empilement de couches 20 servant de matériau de départ à la réalisation du transducteur. L'empilement 20 comprend successivement un substrat 21, une première couche sacrificielle 22 et une première couche structurelle 23, aussi appelée « couche mince ».

Le substrat 21 sert notamment à réaliser le premier bras de transmission 141 et une partie du bâti (le support). Il présente initialement une épaisseur qui peut être comprise entre 500 µm et 700 µm. Le substrat 21 peut être en un matériau semiconducteur, par exemple le silicium.

La première couche structurelle 23 sert à réaliser la membrane 131 du piston 13. Elle peut également servir à réaliser la membrane d'étanchéité 161 de l'articulation pivot 16 et/ou l'électrode mobile 151 des moyens de détection capacitive 15. Elle présente une épaisseur inférieure à celle du substrat 21, de préférence comprise entre 100 nm et 10 µm, par exemple égale à 1 µm. Elle est de préférence constituée du même matériau que le substrat, par exemple le silicium.

La première couche sacrificielle 22 a vocation à disparaître en partie lors de la réalisation du transducteur. Cette couche est notamment utile pour la délimitation du premier bras de transmission 141. Elle peut également servir d'entrefer inférieur dans la zone de détection capacitive du transducteur. Elle peut également permettre de lier mécaniquement le substrat 21 et la première couche structurelle 23. La première couche sacrificielle 22 peut être constituée d'un matériau diélectrique, de préférence un nitrure de silicium ou un oxyde de silicium, par exemple le dioxyde de silicium (SiO₂). Son épaisseur est par exemple comprise entre 100 nm et 10 µm.

L'empilement 20 peut notamment être une structure multicouche de type silicium sur isolant ou SOI (« Silicon On Insulator » en anglais), communément appelée substrat SOI.

Bien que non représentée par les figures, le procédé de fabrication peut ensuite comprendre une étape de gravure de la première couche structurelle 23. Cette étape de gravure de la première couche structurelle 23 peut notamment servir à former des trous de libération de l'électrode mobile 151 (pour laisser s'infiltrer ultérieurement la solution de gravure de la première couche sacrificielle 22).

A l'étape S2 de la figure 2B, une deuxième couche sacrificielle 24 est formée sur la première couche structurelle 23 dans une première zone 20A de l'empilement 20. Pour ce faire, la deuxième couche sacrificielle 24 peut être d'abord déposée de façon à recouvrir entièrement la première couche structurelle 23 puis gravée partiellement dans une deuxième zone 20B de l'empilement 20, par exemple au travers d'un masque en résine formé par photolithographie. Les première et deuxième zones 20A-20B de l'empilement 20 sont adjacentes. La gravure de la deuxième couche sacrificielle 24 est de préférence sélective par rapport à la première couche structurelle 23. La deuxième couche sacrificielle 24 est avantageusement formée du même matériau diélectrique que la première couche sacrificielle 22, par exemple un oxyde de silicium. Son épaisseur peut être comprise entre 100 nm et 10 µm.

La deuxième couche sacrificielle 24 peut servir d'entrefer supérieur pour la détection capacitive. La gravure de la deuxième couche sacrificielle 24 peut entrainer la gravure de la première couche sacrificielle 22, là où la première couche structurelle 23 a préalablement été gravée (non représenté sur les figures).

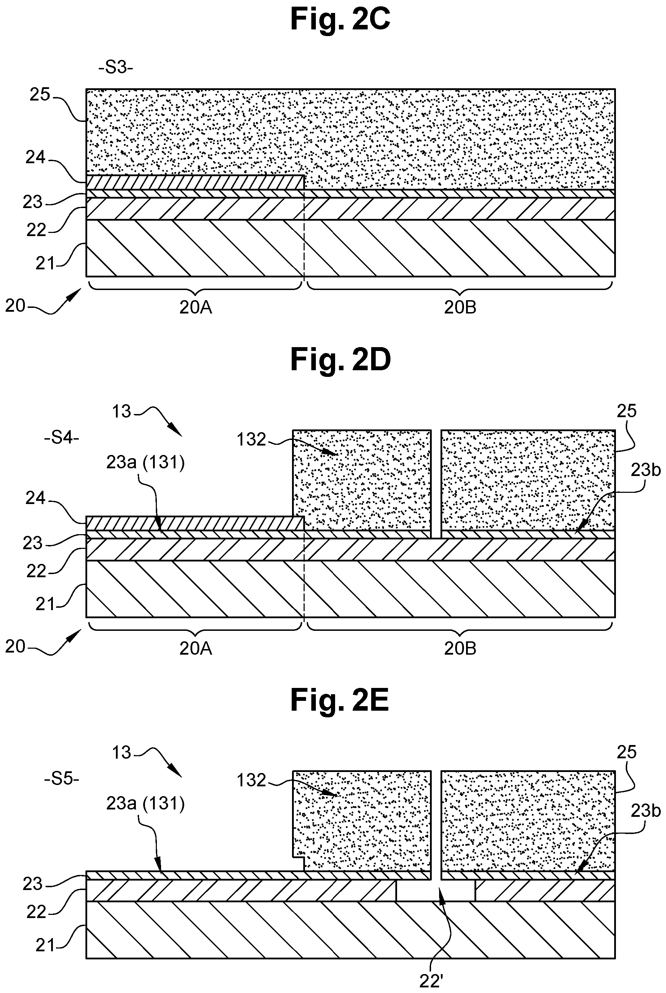

A l'étape S3 de la figure 2C, une deuxième couche structurelle 25 est déposée sur la première couche structurelle 23 (dans la deuxième zone 20B de l'empilement 20) et sur la deuxième couche sacrificielle 24 (dans la première zone 20A de l'empilement 20), par exemple par épitaxie. La deuxième couche structurelle 25 est destinée à former un ou plusieurs éléments (structurels) du transducteur, en particulier la structure de rigidification 132 du piston 13. Elle est avantageusement formée du même matériau que la première couche structurelle 23, par exemple de silicium. L'épaisseur de la deuxième couche structurelle 25 est de préférence comprise entre 5 µm et 50 µm, par exemple égale à 20 µm.

Puis, lors d'une étape S4 représentée par la figure 2D, la deuxième couche structurelle 25 est gravée de façon à délimiter les contours de la structure de rigidification 132 (détourage du piston) et à alléger le piston 13. Dans la première zone 20A de l'empilement 20, la deuxième couche sacrificielle 24 (ex. en oxyde de silicium) sert de couche d'arrêt à la gravure de la deuxième couche structurelle 25 (ex. en silicium), préservant ainsi la première couche structurelle 23 sous-jacente (ex. en silicium). La gravure de la deuxième couche structurelle 25 est donc sélective par rapport à la deuxième couche sacrificielle 24. En revanche, dans la deuxième zone 20B de l'empilement 20, la gravure de la deuxième couche structurelle 25 pour délimiter la périphérie (ou le contour extérieur) de la structure de rigidification 132 débouche sur la première couche structurelle 23. La gravure de la deuxième couche structurelle 25 n'étant pas sélective par rapport à la première couche structurelle 23 (mais uniquement par rapport à la première couche sacrificielle 22), la première couche structurelle 23 est gravée en même temps que la deuxième couche structurelle 25 jusqu'à la première couche sacrificielle 22.

Ainsi, au fond de la tranchée correspondant à la périphérie de la structure de rigidification 132, la première couche structurelle 23 a été gravée et la première couche sacrificielle 22 est exposée.

A l'issue de l'étape S4, la première couche structurelle 23 comprend une première partie 23a et une deuxième partie 23b séparées l'une de l'autre. La première partie 23a de la première couche structurelle 23 (à gauche sur la figure 2D) est destinée à former la membrane 131 du piston 13. Elle est recouverte par la deuxième couche sacrificielle 24 et par une portion désolidarisée de la deuxième couche structurelle 25 formant la structure de rigidification 132 du piston 13.

La technique de gravure employée à l'étape S4 de la figure 2D est avantageusement la gravure ionique réactive profonde (ou DRIE, pour « Deep Reactive Ion Etching » en anglais).

En référence à la figure 2E, le procédé de fabrication comprend ensuite une étape S5 de gravure de la deuxième couche sacrificielle 24 de façon à exposer (partiellement) la première partie 23a de la première couche structurelle 23 (autrement dit de façon à exposer une première face de la membrane 131). Cette étape S5 peut être qualifiée de première étape de libération du piston 13.

La gravure de la deuxième couche sacrificielle 24 est de préférence une gravure isotrope sélective par rapport au substrat 21, à la première couche structurelle 23 et à la deuxième couche structurelle 25. La deuxième couche sacrificielle 24 est de préférence gravée chimiquement, par exemple en plongeant l'empilement dans un bain d'acide fluorhydrique (HF) en phase liquide ou vapeur (dans le cas d'une couche en oxyde de silicium) pendant un temps maîtrisé.

En revanche, une portion de la première couche sacrificielle 22 située à l'aplomb de la périphérie de la structure de rigidification 132 est gravée en même temps que la deuxième couche sacrificielle 24, ce qui forme une cavité 22' dans la première couche sacrificielle 22. La gravure peut être contrôlée en temps de sorte que cette cavité 22' soit peu étendue.

La gravure des couches sacrificielles 22 et 24 peut également servir à libérer l'électrode mobile 151 des moyens de détection capacitive 15 (avant qu'elle ne soit enfermée dans la chambre sous atmosphère contrôlée).

Bien que non représentée par les figures, le procédé de fabrication peut comprendre ensuite une étape S6 de report d'un capot sur la deuxième couche structurelle 25, formant ainsi la chambre sous atmosphère contrôlée, c'est-à-dire la deuxième zone 12. Le capot peut être réalisé par usinage d'un substrat en silicium. Il peut notamment être fixé à la deuxième couche structurelle 25 par collage direct (par exemple Si-Si) ou par scellement eutectique (par exemple Au-Si ou Al-Ge).

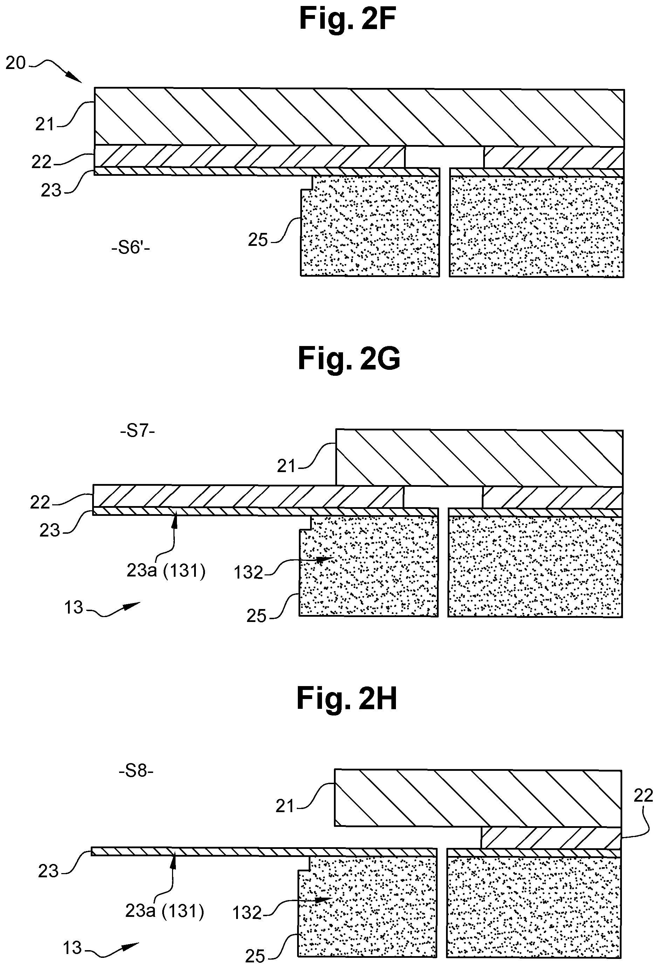

Puis, à l'étape S6' de la figure 2F, l'assemblage formé par l'empilement de couches 20 et le capot (non représenté) est retourné, pour faciliter la gravure ultérieure du substrat 21. Après ce retournement, le substrat 21 est avantageusement aminci, par exemple par gravure DRIE, broyage (« grinding » en anglais) et/ou polissage mécano-chimique (« Chemical mechanical polishing », CMP), de préférence jusqu'à atteindre une épaisseur comprise entre 30 µm à 300 µm, soit l'épaisseur souhaitée pour le premier bras de transmission 141.

L'étape S7 de la figure 2G consiste à graver le substrat 21 (éventuellement aminci) jusqu'à la première couche sacrificielle 22 de façon à créer un accès jusqu'au piston 13 et à délimiter, dans une zone non représentée sur la figure 2G, le premier bras de transmission. La gravure du substrat est de préférence sélective par rapport à la première couche sacrificielle 22. Le substrat 21 peut être gravé par DRIE.

Comme cela est illustré sur la figure 2G, la gravure du substrat 21 pour créer un accès vers la face arrière du piston 13 peut être inscrite à l'intérieur de la périphérie du piston 13, de façon à ne pas déboucher sur la cavité 22' formée à l'étape S5 (cf. Fig. 2E) par la gravure partielle (et involontaire) de la première couche sacrificielle 22. Ainsi, la gravure de l'étape S7 ne s'étend pas au piston 13 comprenant la première partie 23a de la première couche structurelle 23 (membrane 131) et la portion désolidarisée de la deuxième couche structurelle 25 (structure de rigidification 132). A l'intérieur de la périphérie du piston 13, la première couche sacrificielle 22 (ex. en oxyde de silicium) sert de couche d'arrêt à la gravure du substrat 21 (ex. en silicium), préservant ainsi la première partie 23a de la première couche structurelle 23 sous-jacente (ex. en silicium). Cela évite de créer des fuites d'air importantes entre la cavité ouverte sur l'environnement extérieur (et donc soumise à la pression atmosphérique) et le volume de référence (soumis à la pression de référence), aussi appelé volume arrière, de part et d'autre de la membrane 131.

Enfin, à l'étape S8 (cf. Fig. 2H), la première couche sacrificielle 22 est gravée de façon à découvrir la première partie 23a de la première couche structurelle 23 (autrement dit de façon à exposer une deuxième face opposée de la membrane 131) et la désolidariser du substrat 21. A l'issue de l'étape S8, le piston 13 est libre de se déplacer. L'étape S8 peut donc être qualifiée de deuxième étape de libération du piston 13.

La gravure de la première couche sacrificielle 22 est de préférence une gravure isotrope sélective par rapport au substrat 21, à la première couche structurelle 23 et à la deuxième couche structurelle 25. La première couche sacrificielle 22 est de préférence gravée chimiquement, par exemple en plongeant l'assemblage dans un bain d'acide fluorhydrique (HF) en phase liquide ou vapeur (dans le cas d'une couche en oxyde de silicium) pendant un temps maîtrisé.

Lors du déplacement du piston 13, de l'air est pincé entre la membrane 131 et la portion restante du substrat 21, et ce sur quasiment toute la périphérie du piston 13 (cf. Fig.2H). Ce pincement d'air est dû au fait que la gravure du substrat 21 est inscrite à l'intérieur de la périphérie du piston 13. Il est à l'origine d'un phénomène d'amortissement, appelé « squeeze-film damping » en anglais, qui génère du bruit mécanique et entraîne une diminution des performances du transducteur. La force de ce phénomène d'amortissement est inversement proportionnelle au cube de la distance (appelé « gap ») entre le piston 13 et le bâti (soit ici la portion restante du substrat 21).

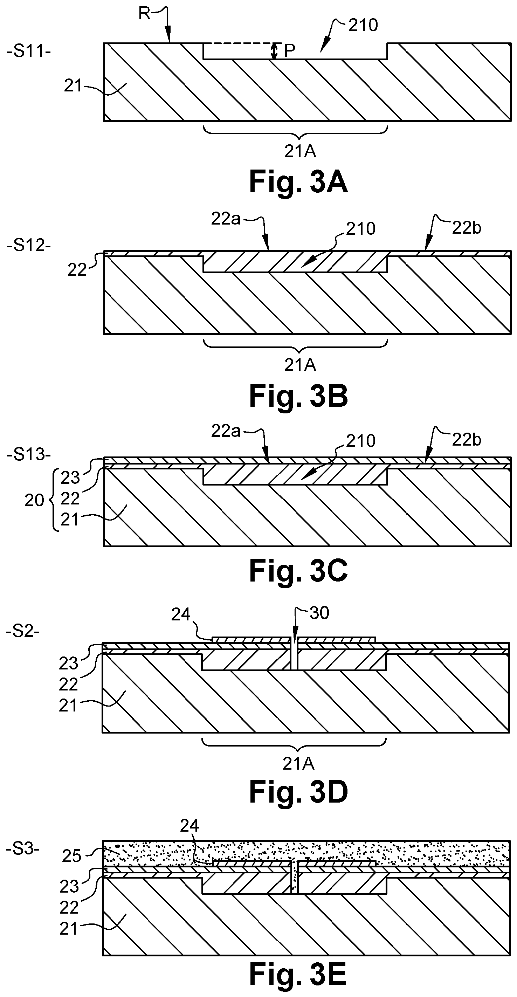

Les figures 3A à 3J illustrent des modifications du procédé de fabrication, permettant de réduire considérablement le phénomène d'amortissement.

Les étapes S11 à S13, illustrées par les figures 3A à 3C, visent à recréer l'empilement multicouche 20 comprenant le substrat 21, la première couche sacrificielle 22 et la première couche structurelle 23, mais en le dotant en outre d'une cavité 210 aménagée à la surface du substrat 21 et remplie par la première couche sacrificielle 22.

Ainsi, en référence à la figure 3A, le procédé de fabrication débute par une étape S11 de gravure de la cavité 210 dans le substrat 21. Le substrat 21 est de préférence un substrat semi-conducteur dit massif (ou « bulk » en anglais), par exemple en silicium. La cavité 210 est située dans une région 21A du substrat 21 dédiée à la formation du piston 13. Elle présente de préférence une profondeur P supérieure ou égale à 1 µm, de préférence comprise entre 2 µm et 10 µm. La profondeur P de la cavité 210 est mesurée depuis la surface initiale du substrat 21, appelée ci-après surface de référence R.

Puis, à l'étape S12 de la figure 3B, la première couche sacrificielle 22 est formée sur le substrat 21. La première couche sacrificielle 22 comprend ici une première portion 22a remplissant entièrement la cavité 210 et une deuxième portion 22b adjacente à la première portion 22a et disposée en dehors de la cavité 210. La première portion 22a présente une épaisseur supérieure à celle de la deuxième portion 22b.

La première couche sacrificielle 22 présente avantageusement une surface plane. L'épaisseur de la première portion 22a est alors égale à la somme de la profondeur P de la cavité 210 et de l'épaisseur de la deuxième portion 22b. L'épaisseur de la deuxième portion 22b de la première couche sacrificielle 22 est par exemple comprise entre 100 nm et 10 µm.

La première couche sacrificielle 22 est avantageusement déposée de manière à remplir entièrement la cavité 210 et à former une surépaisseur sur la surface de référence R du substrat 21. Par exemple, la première couche sacrificielle 22 est formée par dépôt chimique en phase vapeur assisté par plasma (ou PECVD) suivi d'un recuit. Cette opération de dépôt est avantageusement suivie d'une opération de planarisation, par exemple par polissage mécano-chimique (ou CMP, pour « chemical mechanical polishing » en anglais), afin obtenir la surface plane.

A l'étape S13 de la figure 3C, la première couche structurelle 23 est formée sur la première couche sacrificielle 22. La première couche structurelle 23 (qui est pour mémoire destinée à former la membrane 131 du piston 13) recouvre au moins la première portion 22a de la première couche sacrificielle 22. Elle est de préférence déposée de manière à recouvrir les première et deuxième portions 22a-22b de la première couche sacrificielle 22, comme cela est illustré sur la figure 3C.

La première couche structurelle 23 peut être formée à l'étape S13 par épitaxie de silicium sur la première couche sacrificielle 22, typiquement en SiO₂. La première couche structurelle 23 est alors en silicium polycristallin.

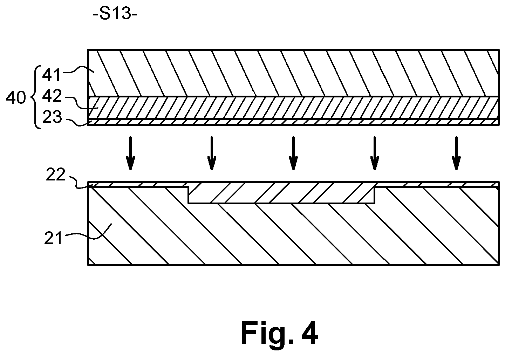

Dans une variante de mise en œuvre de l'étape S13 représentée par la figure 4, la première couche structurelle 23 appartient initialement à un substrat de report 40. Elle est reportée sur la première couche sacrificielle 22 grâce à une technique de collage direct.

Le substrat de report 40 est collé au substrat 21 recouvert de la première couche sacrificielle 22 en mettant en contact la première couche structurelle 23 avec la première couche sacrificielle 22. Puis, le substrat de report 40 est aminci jusqu'à la première couche structurelle 23. L'amincissement du substrat de report 40 peut être accompli par gravure ou CMP.

Le substrat de report 40 est de préférence une structure multicouche de type SOI comprenant successivement une couche de support 41 (typiquement en silicium), une couche d'oxyde enterrée 42 (typiquement en SiO₂) et un film mince de silicium monocristallin formant la première couche structurelle 23. Le substrat de report 40 est aminci en retirant successivement la couche de support 41 et la couche d'oxyde enterrée 42.

Cette variante de mise en œuvre permet de former une première couche structurelle 23 en silicium monocristallin, plutôt qu'en silicium polycristallin.

En référence aux figures 3D à 3J, le procédé de fabrication comprend ensuite les étapes S2 à S8 décrites précédemment, en relation avec les figures 2B à 2H.

La figure 3D représente l'étape S2 de formation de la deuxième couche sacrificielle 24 sur la première couche structurelle 23. La deuxième couche sacrificielle 24 est formée uniquement dans la région 21A dédiée à la formation du piston 13, de préférence de la façon décrite en relation avec la figure 2B (dépôt « pleine plaque » + gravure).

La figure 3E représente l'étape S3 de formation de la deuxième couche structurelle 25 (destinée à former la structure de rigidification 132 du piston 13), par exemple par épitaxie. Comme décrit précédemment en relation avec la figure 2C, la deuxième couche structurelle 25 recouvre à la fois la deuxième couche sacrificielle 24 (dans la région 21A) et la première couche structurelle 23.

Avant l'étape S3 de formation de la deuxième couche structurelle 25, le procédé de fabrication peut comprendre une étape dite d'ouverture de la première couche structurelle 23 et de la deuxième couche sacrificielle 24. Cette étape d'ouverture consiste à former un puits 30 qui s'étend à travers la première couche structurelle 23 et la première couche sacrificielle 22 jusqu'au substrat 21. Ce puits 30 est formé en gravant successivement une portion de la première couche structurelle 23 et une portion de la première couche sacrificielle 22, de préférence à travers la deuxième couche sacrificielle 24. Les portions gravées sont situées dans la région 21A (cf. Fig.3D). Le puits 30 permet au matériau de la deuxième couche structurelle 25 (par exemple du silicium) de croître du substrat 21 jusqu'à la première couche structurelle 23, formant ainsi un pilier qui traverse la première couche sacrificielle 22. Ce pilier assurera la connexion entre la membrane 131 du piston 13 (formée dans la première couche structurelle 23) et le premier bras de transmission 141 (formé dans le substrat 21).

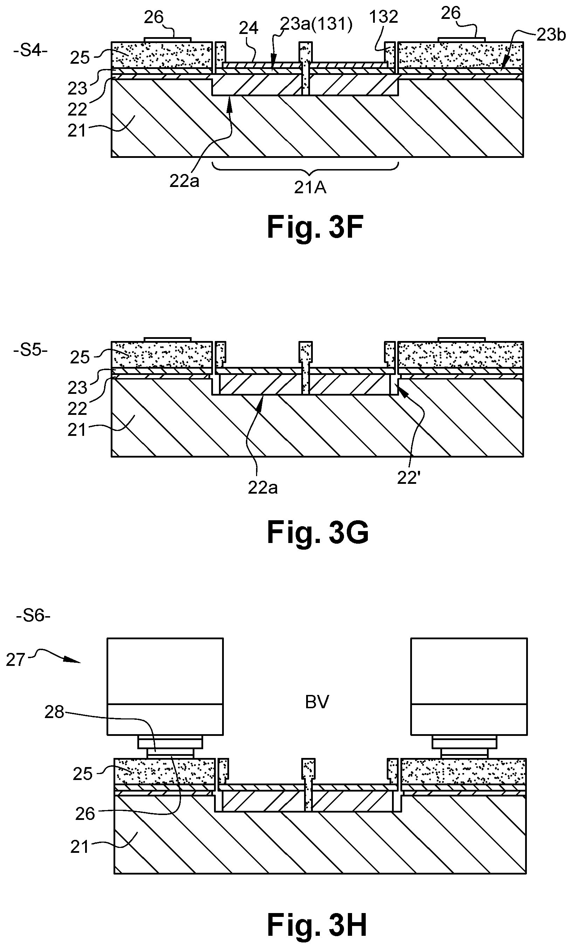

La figure 3F représente l'étape S4 de gravure de la deuxième couche structurelle 25, après son dépôt sur la première couche structurelle 23 et la deuxième couche sacrificielle 24. La deuxième couche structurelle 25 est gravée de façon à exposer la deuxième couche sacrificielle 24 (allégement du piston) et à délimiter la structure de rigidification 132.

Comme décrit précédemment en référence à la figure 2D, la première couche structurelle 23 peut être gravée au cours de la même étape S4 pour délimiter la membrane 131 (tel est généralement le cas lorsque la première couche structurelle 23 et la deuxième couche structurelle 25 sont formées du même matériau). La première couche structurelle 23 est ainsi séparée en deux portions : une première portion 23a formant la membrane 131 du piston et une deuxième portion 23b appartenant au bâti du transducteur.

Une alternative consiste à graver la deuxième couche structurelle 25 et la première couche structurelle 23 séparément, en utilisant des chimies de gravure différentes, lorsque les deux couches sont formées de matériaux différents.

La gravure de la première couche structurelle 23 débouche avantageusement sur la première portion 22a de la première couche sacrificielle 22.

Entre l'étape S3 de formation de la deuxième couche structurelle 25 et l'étape S4 de gravure de la deuxième couche structurelle 25, le procédé de fabrication peut également comprendre des étapes de dépôt et de structuration d'une couche de germanium 26 sur la deuxième couche sacrificielle 25. La couche de germanium 26 est de préférence formée à la périphérie de la première région 21A.

A l'étape S5 de la figure 3G, la deuxième couche sacrificielle 24 est gravée de la façon décrite en référence à la figure 2E (gravure sélective par rapport au substrat 21, à la première couche structurelle 23 et à la deuxième couche structurelle 25), jusqu'à la retirer entièrement. Simultanément, une portion de la première couche sacrificielle 22 est gravée, en partant du fond de la tranchée correspondant à la périphérie de la membrane 131, formant ainsi la cavité 22'. La cavité 22' s'étend au moins en partie sous la membrane 131.

Plus particulièrement, la gravure de la deuxième couche sacrificielle 24 peut s'étendre à la première portion 22a de première sacrificielle 22, comme cela est illustré par la figure 3G.

La figure 3H représente l'étape S6 de report du capot 27 sur la deuxième couche structurelle 25, pour former la chambre sous atmosphère contrôlée et, dans cet exemple, le volume arrière BV du microphone.

Le capot 27 peut être recouvert d'une couche d'aluminium 28 qui est mise en contact avec la couche de germanium 26 afin de réaliser un collage par scellement eutectique aluminium-germanium.

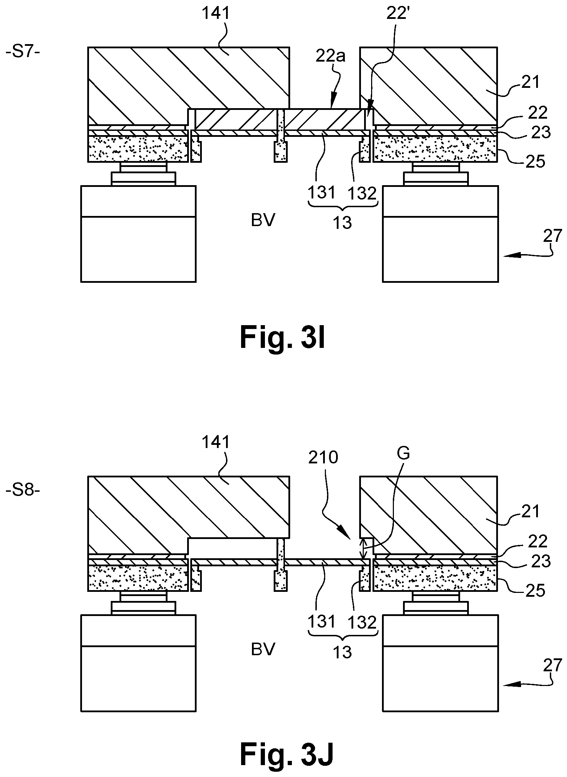

La figure 3I représente l'étape S7 de gravure du substrat 21 (après l'étape S6' de retournement du substrat 21 suivie d'un éventuel amincissement du substrat 21), permettant d'accéder à la face opposée du piston 13 et de délimiter le premier bras de transmission 141. Comme sur la figure 2G, le substrat 21 est gravé en se servant de la première couche sacrificielle 22 comme couche d'arrêt. La gravure du substrat 21 est inscrite à l'intérieur de la périphérie du piston 13, de façon à ne pas déboucher dans la cavité 22'.

En référence à la figure 3J, le procédé de fabrication s'achève par l'étape S8 de gravure de la première couche sacrificielle 22 (et plus particulièrement de sa première portion 22a), comme décrit en relation avec la figure 2H (deuxième étape de libération du piston). La cavité 210 du substrat 21 redevient alors totalement libre.

Le pincement d'air, source d'amortissement et donc de bruit, se produit entre une portion périphérique de la membrane 131 et le substrat 21. Pour réduire le phénomène d'amortissement, la cavité 210 formée à l'étape S11 dans le substrat 21 est configurée de sorte que la première portion 22a de la première couche sacrificielle 22 soit située en regard de la portion périphérique de la membrane 131 (portion en superposition avec le substrat 21). Par « disposée en regard », on entend que la portion périphérique de la membrane 131 et la première portion 22a s'étendent l'une en face de l'autre, au moins en partie (autrement dit, il y a superposition partielle ou totale). La portion périphérique de la membrane 131 est de préférence recouverte par la structure de rigidification 132. La largeur de la portion périphérique est par exemple comprise entre 2 µm et 15 µm.

Une telle configuration permet d'obtenir (après l'étape S8 de gravure de la deuxième couche sacrificielle 22 ; cf. Fig.3J) un gap G plus important entre la membrane 131 du piston 13 et la partie restante du substrat 21, comparativement à la situation où la première couche sacrificielle 22 est d'épaisseur constante (Fig.2H). Le phénomène d'amortissement, dû au pincement d'air, est donc considérablement réduit.

Autrement dit, le substrat 21 et la portion périphérique de la membrane 131 sont éloignées d'une distance (gap G) supérieure à la distance entre le substrat 21 et la deuxième partie 23b de la première couche structurelle 23. Ces distances sont mesurées perpendiculairement aux faces de la membrane 131.

La formation de la cavité 210 résulte en un épaississement local de la première couche sacrificielle 22. Utiliser une première couche sacrificielle 22 d'épaisseur plus importante dans la région 21a du substrat dédiée à la formation du piston 13 (ou au moins en regard de la portion périphérique de la membrane 131) est une solution plus avantageuse que d'augmenter l'épaisseur de toute la première couche sacrificielle 22, car elle n'impacte pas la fabrication des autres parties du microphone (qui font appel à cette première couche sacrificielle 22), comme les moyens de détection capacitive.

La cavité 210 du substrat 21 (et donc la première portion 22a de la première couche sacrificielle 22) peut avoir une forme annulaire. Elle est alors dimensionnée de sorte à s'étendre en regard de la portion périphérique de la membrane 131. La cavité 210 de forme annulaire s'étend de préférence sur plus de 80 % de la périphérie du piston 13, avantageusement sur toute la périphérie du piston 13.

Alternativement, la cavité 210 peut avoir la même forme que la membrane 131, par exemple une forme rectangulaire (cf. Fig.1).

Pour réduire au maximum l'amortissement, les dimensions de la cavité 210 (dimensions extérieures dans le cas d'une cavité 210 annulaire) sont avantageusement supérieures ou égales à celle de la membrane 131.

La première couche sacrificielle 22 comprenant les première et deuxième portions 22a-22b (la première portion 22a étant plus épaisse que la deuxième portion 22b) peut être formée sans graver préalablement de cavité dans le substrat, autrement dit en partant d'un substrat 21 dont la surface est plane. Par exemple, le matériau (sacrificiel) qui constitue la première couche sacrificielle 22 est d'abord déposé sous la forme d'une couche d'épaisseur constante, puis une partie de cette couche est amincie, de préférence par gravure, pour former la deuxième portion 22b (la partie non amincie de la couche formant la première portion 22a).

Le procédé de fabrication de transducteur électroacoustique selon l'invention a été décrit en prenant pour exemple un microphone à détection capacitive (Fig.1), dont une face est soumise à la pression atmosphérique et l'autre face soumise à une pression de référence. Le procédé de fabrication décrit en relation avec les figures 3A-3J, est cependant applicable à d'autres types de microphone et à d'autres types de transducteur électroacoustique, notamment un haut-parleur (émetteur sonore) ou un émetteur ultrasonore.

De façon plus générale, un microphone comprend dans la deuxième zone 12 (chambre à atmosphère contrôlée) des moyens de mesure d'un mouvement du dispositif de transmission et/ou d'une force appliquée au dispositif de transmission. Ces moyens de mesure comprennent par exemple une poutre vibrante (microphone à détection résonante).

Dans le cas d'un haut-parleur ou d'un émetteur ultrasonore, un actionneur (par exemple capacitif) remplace les moyens de mesure dans la deuxième zone 22. L'actionneur met en mouvement la première extrémité du deuxième bras de transmission 142. Ce mouvement est transmis par le dispositif de transmission 14 au piston 13 solidaire de la première extrémité du premier bras de transmission 141. Le mouvement de la membrane 131 du piston 13 permet d'émettre un son (ou des ultrasons).

## Revendications

1. Procédé de fabrication d'un transducteur électroacoustique (1) comprenant :
- un bâti ;
- un élément mobile (13) par rapport au bâti, l'élément mobile (13) comprenant une membrane (131) et une structure de rigidification (132) de la membrane ;
- un premier bras de transmission (141), l'élément mobile (13) étant couplé à une extrémité du premier bras de transmission (141) ;
procédé comprenant les étapes suivantes :
- former (S12) une première couche sacrificielle (22) sur un substrat (21), la première couche sacrificielle comprenant une première portion (22a) et une deuxième portion (22b) adjacente à la première portion (22a), la première portion (22a) ayant une épaisseur supérieure à celle de la deuxième portion (22b) ;
- former (S13) une première couche structurelle (23) sur la première couche sacrificielle (22), obtenant ainsi un empilement multicouche (20) ;
- former (S2) une deuxième couche sacrificielle (24) sur la première couche structurelle (23) dans une première zone (20A) de l'empilement multicouche (20) ;
- former (S3) une deuxième couche structurelle (25) sur la première couche structurelle (23) dans une deuxième zone (20B) de l'empilement multicouche (20) et sur la deuxième couche sacrificielle (24) dans la première zone (20A) de l'empilement multicouche (20), la deuxième zone (20B) étant adjacente à la première zone (20A) ;
- graver (S4) la deuxième couche structurelle (25) de façon à exposer la deuxième couche sacrificielle (24) dans la première zone (20A) et à délimiter la périphérie de la structure de rigidification (132) de l'élément mobile (13) dans la deuxième zone (20B) ;
- graver (S4) dans la deuxième zone (20B) la première couche structurelle (23) jusqu'à la première couche sacrificielle (22) de façon à délimiter la membrane (131) de l'élément mobile (13) ;
- graver (S5) la deuxième couche sacrificielle (24) de façon à exposer une première face de la membrane (131) ;
- graver (S7) le substrat (21) de façon à délimiter le premier bras de transmission (141), la première couche sacrificielle (22) servant de couche d'arrêt à la gravure du substrat ; et
- graver (S8) la première couche sacrificielle (22) de façon à exposer une deuxième face opposée de la membrane (131) et désolidariser la membrane (131) du substrat (21) ;
procédé dans lequel la première portion (22a) de la première couche sacrificielle (22) est configurée pour que, après l'étape de gravure (S4) de la première couche structurelle (23), une portion périphérique de la membrane (131) soit disposée en regard de la première portion (22a) de la première couche sacrificielle (22).

2. Procédé selon la revendication 1, comprenant, avant l'étape (S12) de formation de la première couche sacrificielle (22), une étape (S11) de gravure d'une cavité (210) dans le substrat (21), la première portion (22a) de la première couche sacrificielle (22) remplissant entièrement la cavité (210) et la deuxième portion (22b) de la première couche sacrificielle (22) étant disposée en dehors de la cavité (210).

3. Procédé selon la revendication 2, dans lequel la cavité (210) présente une profondeur (P) supérieure ou égale à 1 µm, de préférence comprise entre 2 µm et 10 µm.

4. Procédé selon l'une des revendications 2 et 3, dans lequel la cavité (210) présente une forme annulaire.

5. Procédé selon la revendication 4, dans lequel la cavité (210) s'étend sur plus de 80 % de la périphérie de l'élément mobile (13).

6. Procédé selon l'une des revendications 2 et 3, dans lequel la cavité (210) et la membrane (131) sont de même forme, de préférence de forme rectangulaire.

7. Procédé selon l'une quelconque des revendications 2 à 6, dans lequel la cavité (210) présente des dimensions supérieures ou égales aux dimensions de la membrane (131).

8. Procédé selon l'une quelconque des revendications 1 à 7, dans lequel la première couche structurelle (23) et la deuxième couche structurelle (25) sont gravées simultanément de façon à délimiter la membrane (131) et la structure de rigidification (132) de l'élément mobile (13).

9. Procédé selon l'une quelconque des revendications 1 à 8, comprenant en outre, après l'étape (S5) de gravure de la deuxième couche sacrificielle (24) et avant l'étape (S7) de gravure du substrat (21), les étapes suivantes :
- disposer (S6) un capot (27) sur la deuxième couche structurelle (25), formant ainsi un assemblage ; et
- retourner (S6') l'assemblage.

10. Procédé selon l'une quelconque des revendications 1 à 9, dans lequel le substrat (21) est en silicium, la première couche sacrificielle (22) est en oxyde de silicium et la première couche structurelle (23) est en silicium.

11. Procédé selon l'une quelconque des revendications 1 à 10, dans lequel la deuxième couche sacrificielle (24) est en oxyde de silicium.

12. Procédé selon l'une quelconque des revendications 1 à 11, dans lequel la première couche structurelle (23) est formée par épitaxie sur la première couche sacrificielle (22).

13. Procédé selon l'une quelconque des revendications 1 à 11, dans lequel l'étape de formation de la première couche structurelle (23) comprend les sous-étapes suivantes :
- fournir un substrat de report (40) comprenant la première couche structurelle (23) ;
- coller la première couche structurelle (23) du substrat de report (40) à la première couche sacrificielle (22) ;
- amincir le substrat de report (40) jusqu'à atteindre la première couche structurelle (23).

14. Procédé selon la revendication 13, dans lequel le substrat de report est une structure multicouche de type silicium sur isolant.

15. Transducteur électroacoustique (1) comprenant :
- un bâti ;
- un élément mobile (13) par rapport au bâti, l'élément mobile (13) comprenant une membrane (131) et une structure de rigidification (132) de la membrane ;
- un premier bras de transmission (141), l'élément mobile (13) étant couplé à une extrémité du premier bras de transmission (141) ;
la membrane (131) étant formée par une première partie (23a) d'une première couche structurelle (23), la structure de rigidification (132) étant formée par une première partie d'une deuxième couche structurelle (25) disposée sur la première couche structurelle (23) et le bâti comprenant un substrat (21), une deuxième partie (23b) de la première couche structurelle (23) et une deuxième partie de la deuxième couche structurelle (25),
**caractérisé en ce que** la distance (G) entre le substrat (21) et une portion périphérique de la membrane (131) est supérieure à la distance entre le substrat (21) et la deuxième partie (23b) de la première couche structurelle (23), lesdites distances étant mesurées perpendiculairement à des faces de la membrane (131).

16. Transducteur électroacoustique (1) selon la revendication 15, dans lequel le substrat (21) comprend une cavité (210) disposée en regard de la portion périphérique de la membrane (131).

## Patentansprüche

1. Verfahren zur Herstellung eines elektroakustischen Wandlers (1), umfassend:
- einen Rahmen;
- ein relativ zum Rahmen bewegliches Element (13), wobei das bewegliche Element (13) eine Membran (131) und eine Versteifungsstruktur (132) für die Membran umfasst;
- einen ersten Übertragungsarm (141), wobei das bewegliche Element (13) mit einem Ende des ersten Übertragungsarms (141) verbunden ist;
Verfahren mit den folgenden Schritten:
- Bilden (S12) einer ersten Opferschicht (22) auf einem Substrat (21), wobei die erste Opferschicht einen ersten Abschnitt (22a) und einen zweiten Abschnitt (22b) benachbart zum ersten Abschnitt (22a) umfasst, wobei der erste Abschnitt (22a) eine größere Dicke als der zweite Abschnitt (22b) aufweist;
- Bilden (S13) einer ersten Strukturschicht (23) auf der ersten Opferschicht (22), wodurch ein Mehrschichtstapel (20) erhalten wird;
- Bilden (S2) einer zweiten Opferschicht (24) auf der ersten Strukturschicht (23) in einem ersten Bereich (20A) des Mehrschichtstapels (20);
- Bilden (S3) einer zweiten Strukturschicht (25) auf der ersten Strukturschicht (23) in einem zweiten Bereich (20B) des Mehrschichtstapels (20) und auf der zweiten Opferschicht (24) im ersten Bereich (20A) des Mehrschichtstapels (20), wobei der zweite Bereich (20B) an den ersten Bereich (20A) angrenzt;
- Ätzen (S4) der zweiten Strukturschicht (25), um die zweite Opferschicht (24) im ersten Bereich (20A) freizulegen und den Umfang der Versteifungsstruktur (132) des beweglichen Elements (13) im zweiten Bereich (20B) zu begrenzen;
- Ätzen (S4) der ersten Strukturschicht (23) im zweiten Bereich (20B) bis zur ersten Opferschicht (22), um die Membran (131) des beweglichen Elements (13) zu begrenzen;
- Ätzen (S5) der zweiten Opferschicht (24), um eine erste Seite der Membran (131) freizulegen;
- Ätzen (S7) des Substrats (21), um den ersten Übertragungsarm (141) abzugrenzen, wobei die erste Opferschicht (22) als Stoppschicht für das Ätzen des Substrats dient; und
- Ätzen (S8) der ersten Opferschicht (22), um eine zweite gegenüberliegende Seite der Membran (131) freizulegen und die Membran (131) vom Substrat (21) zu trennen;
wobei der erste Abschnitt (22a) der ersten Opferschicht (22) so gestaltet ist, dass nach dem Ätzschritt (S4) der ersten Strukturschicht (23) ein peripherer Abschnitt der Membran (131) gegenüber dem ersten Abschnitt (22a) der ersten Opferschicht (22) angeordnet ist.

2. Verfahren nach Anspruch 1, das vor dem Schritt (S12) zum Ausbilden der ersten Opferschicht (22) einen Schritt (S11) zum Ätzen eines Hohlraums (210) in das Substrat (21) umfasst, wobei der erste Abschnitt (22a) der ersten Opferschicht (22) den Hohlraum (210) vollständig ausfüllt und der zweite Abschnitt (22b) der ersten Opferschicht (22) außerhalb des Hohlraums (210) angeordnet ist.

3. Verfahren nach Anspruch 2, bei dem der Hohlraum (210) eine Tiefe (P) von mindestens 1 µm, vorzugsweise zwischen 2 µm und 10 µm, aufweist.

4. Verfahren nach einem der Ansprüche 2 und 3, bei dem der Hohlraum (210) eine ringförmige Form aufweist.

5. Verfahren nach Anspruch 4, bei dem sich der Hohlraum (210) über mehr als 80 % des Umfangs des beweglichen Elements (13) erstreckt.

6. Verfahren nach einem der Ansprüche 2 und 3, bei dem der Hohlraum (210) und die Membran (131) die gleiche Form haben, vorzugsweise eine rechteckige Form.

7. Verfahren nach einem der Ansprüche 2 bis 6, bei dem der Hohlraum (210) Abmessungen aufweist, die größer oder gleich den Abmessungen der Membran (131) sind.

8. Verfahren nach einem der Ansprüche 1 bis 7, bei dem die erste Strukturschicht (23) und die zweite Strukturschicht (25) gleichzeitig geätzt werden, um die Membran (131) und die Versteifungsstruktur (132) des beweglichen Elements (13) abzugrenzen.

9. Verfahren nach einem der Ansprüche 1 bis 8, das nach dem Schritt (S5) des Ätzens der zweiten Opferschicht (24) und vor dem Schritt (S7) des Ätzens des Substrats (21) außerdem die folgenden Schritte umfasst:
- Anbringen (S6) einer Abdeckung (27) auf der zweiten Strukturschicht (25), wodurch eine Anordnung gebildet wird; und
- Umdrehen (S6') der Anordnung.

10. Verfahren nach einem der Ansprüche 1 bis 9, bei dem das Substrat (21) aus Silizium, die erste Opferschicht (22) aus Siliziumoxid und die erste Strukturschicht (23) aus Silizium besteht.

11. Verfahren nach einem der Ansprüche 1 bis 10, bei dem die zweite Opferschicht (24) aus Siliziumoxid besteht.

12. Verfahren nach einem der Ansprüche 1 bis 11, bei dem die erste Strukturschicht (23) durch Epitaxie auf der ersten Opferschicht (22) gebildet wird.

13. Verfahren nach einem der Ansprüche 1 bis 11, bei dem der Schritt des Bildens der ersten Strukturschicht (23) die folgenden Unterschritte umfasst:
- Bereitstellen eines Transfersubstrats (40) mit der ersten Strukturschicht (23);
- Aufkleben der ersten Strukturschicht (23) des Transfersubstrats (40) auf die erste Opferschicht (22);
- Verdünnen des Transfersubstrats (40) bis zur ersten Strukturschicht (23).

14. Verfahren nach Anspruch 13, bei dem das Transfersubstrat eine mehrschichtige Struktur vom Typ Silizium auf Isolator ist.

15. Elektroakustischer Wandler (1), umfassend:
- einen Rahmen;
- ein relativ zum Rahmen bewegliches Element (13), wobei das bewegliche Element (13) eine Membran (131) und eine Versteifungsstruktur (132) für die Membran umfasst;
- einen ersten Übertragungsarm (141), wobei das bewegliche Element (13) mit einem Ende des ersten Übertragungsarms (141) verbunden ist;
wobei die Membran (131) durch einen ersten Teil (23a) einer ersten Strukturschicht (23) gebildet ist, wobei die Versteifungsstruktur (132) durch einen ersten Teil einer zweiten Strukturschicht (25) gebildet wird, die auf der ersten Strukturschicht (23) angeordnet ist, und wobei der Rahmen ein Substrat (21), einen zweiten Teil (23b) der ersten Strukturschicht (23) und einen zweiten Teil der zweiten Strukturschicht (25) umfasst,
**dadurch gekennzeichnet, dass**
der Abstand (G) zwischen dem Substrat (21) und einem Umfangsabschnitt der Membran (131) größer ist als der Abstand zwischen dem Substrat (21) und dem zweiten Teil (23b) der ersten Strukturschicht (23), wobei die Abstände senkrecht zu den Flächen der Membran (131) gemessen werden.

16. Elektroakustischer Wandler (1) nach Anspruch 15, bei dem das Substrat (21) einen Hohlraum (210) umfasst, der gegenüber dem Umfangsabschnitt der Membran (131) angeordnet ist.

## Claims

1. A method for manufacturing an electroacoustic transducer (1) comprising:
- a frame;
- an element (13) movable relative to the frame, the movable element (13) comprising a membrane (131) and a membrane rigidifying structure (132);
- a first transmission arm (141), the movable element (13) being coupled to one end of the first transmission arm (141);
method comprising the following steps of:
- forming (S12) a first sacrificial layer (22) on a substrate (21), the first sacrificial layer comprising a first portion (22a) and a second portion (22b) adjacent to the first portion (22a), the first portion (22a) having a greater thickness than the second portion (22b);
- forming (S13) a first structural layer (23) on the first sacrificial layer (22), thus obtaining a stack (20) of layers;
- forming (S2) a second sacrificial layer (24) on the first structural layer (23) in a first region (20A) of the stack (20);
- forming (S3) a second structural layer (25) on the first structural layer (23) in a second region (20B) of the stack (20) and on the second sacrificial layer (24) in the first region (20A) of the stack (20), the second region (20B) being adjacent to the first region (20A);
- etching (S4) the second structural layer (25) so as to expose the second sacrificial layer (24) in the first region (20A) and to delimit the periphery of the rigidifying structure (132) of the movable element (13) in the second region (20B);
- etching (S4) in the second region (20B) the first structural layer (23) up to the first sacrificial layer (22) so as to delimit the membrane (131) of the movable element (13);
- etching (S5) the second sacrificial layer (24) so as to expose a first face of the membrane (131);
- etching (S7) the substrate (21) so as to delimit the first transmission arm (141), the first sacrificial layer (22) acting as a stop layer to etching of the substrate; and
- etching (S8) the first sacrificial layer (22) so as to expose a second, opposite face of the membrane (131) and to detach the membrane (131) from the substrate (21)
Method wherein the first portion (22a) of the first sacrificial layer (22) is configured to, after etching (S4) of the first structural layer (23), a peripheral portion of the membrane (131) is arranged facing the first portion (22a) of the first sacrificial layer (22).

2. The method according to claim 1, comprising, prior to the step (S12) of forming the first sacrificial layer (22), a step (S11) of etching a cavity (210) in the substrate (21), the first portion (22a) of the first sacrificial layer (22) completely filling the cavity (210), and the second portion (22b) of the first sacrificial layer (22) being arranged outside the cavity (210).

3. The method according to claim 2, wherein the cavity (210) has a depth (P) greater than or equal to 1 µm, preferably between 2 µm and 10 µm.

4. The method according to any of claims 2 and 3, wherein the cavity (210) has an annular shape.

5. The method according to claim 4, wherein the cavity (210) extends over more than 80% of the periphery of the movable element (13).

6. The method according to any of claims 2 and 3, wherein the cavity (210) and the membrane (131) are of the same, preferably rectangular, shape.

7. The method according to any of claims 2 to 6, wherein the cavity (210) has dimensions greater than or equal to the dimensions of the membrane (131).

8. The method according to any of claims 1 to 7, wherein the first structural layer (23) and the second structural layer (25) are simultaneously etched so as to delimit the membrane (131) and the rigidifying structure (132) of the movable element (13).

9. The method according to any of claims 1 to 8, further comprising, after the step (S5) of etching the second sacrificial layer (24) and before the step (S7) of etching the substrate (21), the following steps of:
- arranging (S6) a cap (27) on the second structural layer (25), thereby forming an assembly; and
- turning over (S6') the assembly.

10. The method according to any of claims 1 to 9, wherein the substrate (21) is of silicon, the first sacrificial layer (22) is of silicon oxide, and the first structural layer (23) is of silicon.

11. The method according to any of claims 1 to 10, wherein the second sacrificial layer (24) is of silicon oxide.

12. The method according to any of claims 1 to 11, wherein the first structural layer (23) is formed by epitaxy on the first sacrificial layer (22).

13. The method according to any of claims 1 to 11, wherein the step of forming the first structural layer (23) comprises the following substeps of:
- providing a transfer substrate (40) comprising the first structural layer (23);
- bonding the first structural layer (23) of the transfer substrate (40) to the first sacrificial layer (22);
- thinning the transfer substrate (40) until the first structural layer (23) is reached.

14. The method according to claim 13, wherein the transfer substrate is a multilayer silicon-on-insulator type structure.

15. An electroacoustic transducer (1) comprising:
- a frame;
- an element (13) movable relative to the frame, the movable element (13) comprising a membrane (131) and a membrane rigidifying structure (132);
- a first transmission arm (141), the movable element (13) being coupled to one end of the first transmission arm (141);
the membrane (131) being formed by a first part (23a) of a first structural layer (23), the rigidifying structure (132) being formed by a first part of a second structural layer (25) arranged on the first structural layer (23), and the frame comprising a substrate (21), a second part (23b) of the first structural layer (23) and a second part of the second structural layer (25),
**characterized in that** the distance (G) between the substrate (21) and a peripheral portion of the membrane (131) is greater than the distance between the substrate (21) and the second part (23b) of the first structural layer (23), said distances being measures perpendicularly to faces of the membrane (131).

16. The electroacoustic transducer (1) according to claim 15, wherein the substrate (21) comprises a cavity (210) arranged facing the peripheral portion of the membrane (131).
